Europäisches Patentamt

European Patent Office

Office européen des brevets

(19)

(11) **EP 1 203 451 B1**

(12) **EUROPÄISCHE PATENTSCHRIFT**

(45) Veröffentlichungstag und Bekanntmachung des Hinweises auf die Patenterteilung:
**21.05.2003 Patentblatt 2003/21**

(21) Anmeldenummer: **00958376.6**

(22) Anmeldetag: **03.08.2000**

(51) Int Cl.⁷: $H03L\ 7/197$, $H03K\ 23/00$

(86) Internationale Anmeldenummer:
**PCT/EP00/07543**

(87) Internationale Veröffentlichungsnummer:
**WO 01/011784 (15.02.2001 Gazette 2001/07)**

(54) **FREQUENZSYNTHESIZER**

FREQUENCY SYNTHESISER

SYNTHETISEUR DE FREQUENCE

(84) Benannte Vertragsstaaten:
**DE FR GB**

(30) Priorität: **09.08.1999 DE 19937608**

(43) Veröffentlichungstag der Anmeldung:
**08.05.2002 Patentblatt 2002/19**

(73) Patentinhaber: **Rohde & Schwarz GmbH & Co. KG
D-81671 München (DE)**

(72) Erfinder:
- **ROTH, Alexander
  84405 Dorfen (DE)**
- **ORTLER, Georg
  86459 Gessertshausen (DE)**

(74) Vertreter: **Körfer, Thomas, Dipl.-Phys.
Mitscherlich & Partner,
Patent- und Rechtsanwälte,
Sonnenstrasse 33
80331 München (DE)**

(56) Entgegenhaltungen:
WO-A-98/34339        DE-A- 19 640 072

- **RILEY T A D ET AL: "A SIMPLIFIED
  CONTINUOUS PHASE MODULATOR
  TECHNIQUE" IEEE TRANSACTIONS ON
  CIRCUITS AND SYSTEMS II: ANALOG AND
  DIGITAL SIGNAL PROCESSING,US,IEEE INC.
  NEW YORK, Bd. 41, Nr. 5, 1. Mai 1994
  (1994-05-01), Seiten 321-328, XP000460168
  ISSN: 1057-7130**
- **ICHIGE K ET AL: "An automatic design
  procedure of IIR digital filters from an analog
  low-pass filter" SIGNAL PROCESSING.
  EUROPEAN JOURNAL DEVOTED TO THE
  METHODS AND APPLICATIONS OF SIGNAL
  PROCESSING,NL,ELSEVIER SCIENCE
  PUBLISHERS B.V. AMSTERDAM, Bd. 57, Nr. 3, 1.
  März 1997 (1997-03-01), Seiten 223-231,
  XP004073571 ISSN: 0165-1684**

EP 1 203 451 B1

**Beschreibung**

Die Erfindung betrifft einen nach dem Prinzip der fraktionalen Frequenzsynthese arbeitenden Frequenzsynthesizer laut Oberbegriff des Hauptanspruches.

Synthesizer dieser Art sind bekannt (z.B. nach Offenlegungsschrift DE 196 40 072 A1). Der Integrator besteht bei den bekannten Synthesizern aus mehreren in Kette geschalteten Integratorschaltungen, in deren Rückkopplungskreis Begrenzer bzw. Bewertungsglieder angeordnet sind. Diese Begrenzer bzw. Bewertungsglieder sind nötig, um die Regelverstärkung so weit zu reduzieren, daß der Regelkreis stabil ist. Dadurch wird allerdings auch die Unterdrückung des Quantisierungsgeräusches nahe am Träger reduziert, die durch die Verstärkung der offenen Regelschleife definiert ist.

Neben analogen Integratorschaltungen werden bei Frequenz-Synthesizern auch digitale rekursive IIR- (Infinite-Impukse-Response)-Filter eingesetzt (WO 98/34339). Diese werden zwischen Modulationsdaten-Quelle und Modulator in Serie zum PLL-Regelkreis geschaltet und verändern mittels Pol-Nullstellen-Kompensation das Übertragungsverhalten zwischen Modulationsdaten-Quelle und Oszillatorausgang. Das Übertragungsverhalten wird nicht mehr durch die niedrige Grenzfrequenz des PLL-Regelkreises bestimmt, sondern weist eine deutlich höhere Grenzfrequenz auf, so daß damit die konkurrierenden Anforderungen der optimaler Übertragung des Modulationssignals und der optimalen Dämpfung des hochfrequenten Rauschens besser erfüllt werden.

Es ist Aufgabe der Erfindung, einen Synthesizer der eingangs erwähnten Art zu schaffen, der einen stabilen Regelkreis und trotzdem möglichst hohe Schleifenverstärkung aufweist.

Diese Aufgabe wird gelöst durch einen Frequenzsynthesizer laut Hauptanspruch. Vorteilhafte Weiterbildungen ergeben sich aus den Unteransprüchen.

Beim erfindungsgemäßen Frequenzsynthesizer ist durch die Verwendung von an sich bekannten IIR-Tiefpaßfiltern eine hohe Schleifenverstärkung und trotzdem ein stabiler Regelkreis möglich, ohne die Aussteuerung am Frequenzteiler mehr als notwendig zu erhöhen. Begrenzende Elemente im Rückkopplungskreis werden vermieden, der Vorkommaanteil des Korrekturwertes wird unmittelbar zum Eingang rückgekoppelt. IIR- (Infinite Impulse Response)-Filter sind bekannt und werden beispielsweise in dem Buch von H. Götz, Einführung in die digitale Signalverarbeitung, Teubner Studienskripten, Seite 220, näher beschrieben. Über die fein einstellbaren Multiplizierer der IIR-Filter ist eine optimale Einstellung der Regelcharakteristik und daher eine möglichst hohe Schleifenverstärkung möglich, die ihrerseits eine optimale Unterdrückung des Quantisierungsgeräusches nahe am Träger gewährleistet, ohne daß die Aussteuerung am Frequenzteiler mehr als notwendig erhöht wird. Die kleine Aussteuerung am Frequenzteiler ermöglicht die Einstellung sehr kleiner Teilungsfaktoren, was wiederum Vorteile bezüglich des Phasenrauschens und der Einstellgeschwindigkeit mit sich bringt. Durch Optimieren von Phasengang und Dämpfungsverlauf kann die Regelschleife so ausgelegt werden, daß ein stabiler Regelkreis entsteht. Über die Wahl der Filterkoeffizienten kann das Rauschprofil des Quantisierungsgeräusches entsprechend eingestellt werden. Die Ordnung des Filters wird durch die Anzahl der Register und Multiplizierer bestimmt. Mit einem Filter zweiter Ordnung läßt sich beispielsweise ein Abfall des Quantisierungsgeräusches am Träger mit ca. 20dB pro Dekade erreichen, mit einem Filter dritter Ordnung ein Abfall von 40dB pro Dekade usw.. Die Ordnung des Filters kann im Prinzip beliebig erhöht werden, solange die Bemessungsregeln für Regelkreise eingehalten werden, d.h. die Phasendrehung in der Nähe der Regelbandbreite muß kleiner als 180° bleiben.

Die Erfindung wird im Folgenden anhand schematischer Zeichnungen an einem Ausführungsbeispiel näher erläutert.

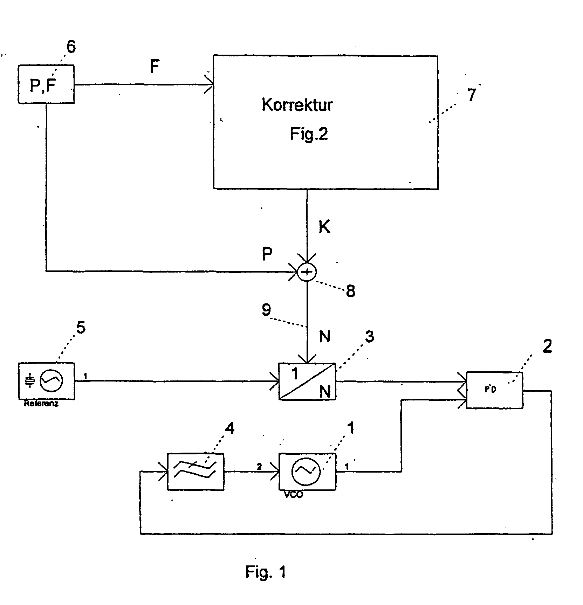

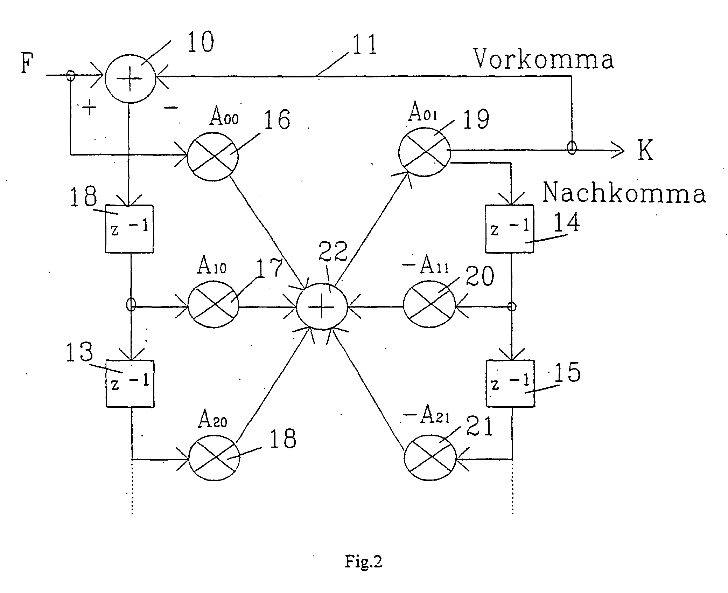

Figur 1 zeigt das Prinzipschaltbild eines nach dem Prinzip der fraktionalen Frequenzsynthese arbeitenden Frequenzsynthesizers und zwar mit Anordnung des fraktionalen Frequenzteilers 3 in der Referenz. Der Synthesizer besteht aus einem phasengeregelten Oszillator 1, einem Phasendetektor 2 sowie einem in der Steuerleitung zwischen Phasendetektor 2 und dem in der Frequenz einstellbaren Oszillator 1 angeordneten Schleifenfilter 4. Zwischen einer Referenzfrequenzquelle 5 und dem Phasendetektor 2 ist der fraktionale Frequenzteiler 3 angeordnet, der auf ganzzahlige Teilungsverhältnisse N einstellbar ist. Mit diesem Frequenzteiler 3 wird die Referenzfrequenz $f_r$ um den Faktor N auf eine Frequenz $f_i$ geteilt und im Phasendetektor 2 mit der gegebenenfalls durch einen nicht dargestellten weiteren Frequenzteiler geteilten Ausgangsfrequenz $f_o$ des Oszillators 1 verglichen. Das Teilungsverhältnis N des Frequenzteilers 3 wird über eine Steuerschaltung 7 eingestellt, die ihrerseits über eine Einstellvorrichtung 6 gesteuert wird. In der Einstellvorrichtung 6 kann ein gewünschtes gebrochen rationales Teilungsverhältnis P, F mit einem ganzzahligen Anteil P und einem gebrochenen Anteil F als entsprechender Digitalwert eingestellt werden. In der Steuerschaltung 7, die in Figur 2 näher beschrieben ist, wird aus dem gebrochenen Anteil F ein Korrekturwert K erzeugt, der in einem Addierer 8 dem ganzzahligen Anteil P hinzuaddiert wird. Mit dem Ausgangssignal 9 dieses Addierers 8 wird der Faktor N des Frequenzteilers 3 eingestellt.

Figur 2 zeigt Einzelheiten der Steuerschaltung 7, in welcher der gebrochene Anteil F des eingestellten gewünschten Teilungsverhältnisses aufintegriert wird. Dies erfolgt gemäß Figur 2 mittels eines bekannten IIR-Tiefpaßfilters, das in dem gezeigten Ausführungsbeispiel als IIR-Tiefpaßfilter zweiter Ordnung ausgebildet ist. Der gebrochene Anteil F des gewünschten Teilungsverhältnisses wird einem Addierer 10 zugeführt und es wird dort der am Ausgang des Filters erzeugte integrierte ganzzahlige Korrekturwert K über die Rückkopplungsleitung 11 hinzuaddiert. Die Differenz zwischen dem rückgekoppelten Korrekturwert K und dem Eingangssignal F wird dem ersten Register 12 des Filters zugeführt. Das Eingangssignal F wird über die Register 12 bis 15 verzögert und über die Multiplizierer 17, 18, 20, 21 gewichtet zum ebenfalls gewichteten Eingangssignal F addiert. Die Register 12 bis 15 sind als Verzögerungsglieder ausgebildet, sie verzögern die Signale jeweils um einen Takt. Die Übertragungsfunktion eines solchen IIR-Tiefpaßfilters ergibt sich aus den Koeffizienten A wie folgt:

$$\frac{A_{00} + A_{10} \cdot z^{-1} + A_{20} \cdot z^{-2} + ...}{A_{01} + A_{11} \cdot z^{-1} + A_{21} \cdot z^{-2} + ...}$$

Die Filtercharakteristik wird also allein über die Koeffizienten an den Multiplizierern eingestellt.

In der Praxis werden die Koeffizienten $A_{00}$ und $A_{01}$ sinnvollerweise gleich 1 gesetzt, dadurch ergibt sich die Möglichkeit, die Korrekturwerte K direkt aus dem Vorkommawert des Addierers 22 zu erzeugen. In dem Register 14 wird nur der Nachkommaanteil des integrierten Wertes des Eingangssignales F verarbeitet, dies hat den gleichen Effekt als wenn durch eine direkte-Rückkopplung der Vorkommaanteil sofort wieder subtrahiert würde. Für das Register 12 wird im Addierer 10 der Vorkommaanteil des Korrekturwertes K vom Eingangssignal F subtrahiert, die Differenz wird synchron zum Steuertakt vom Register 12 übernommen.

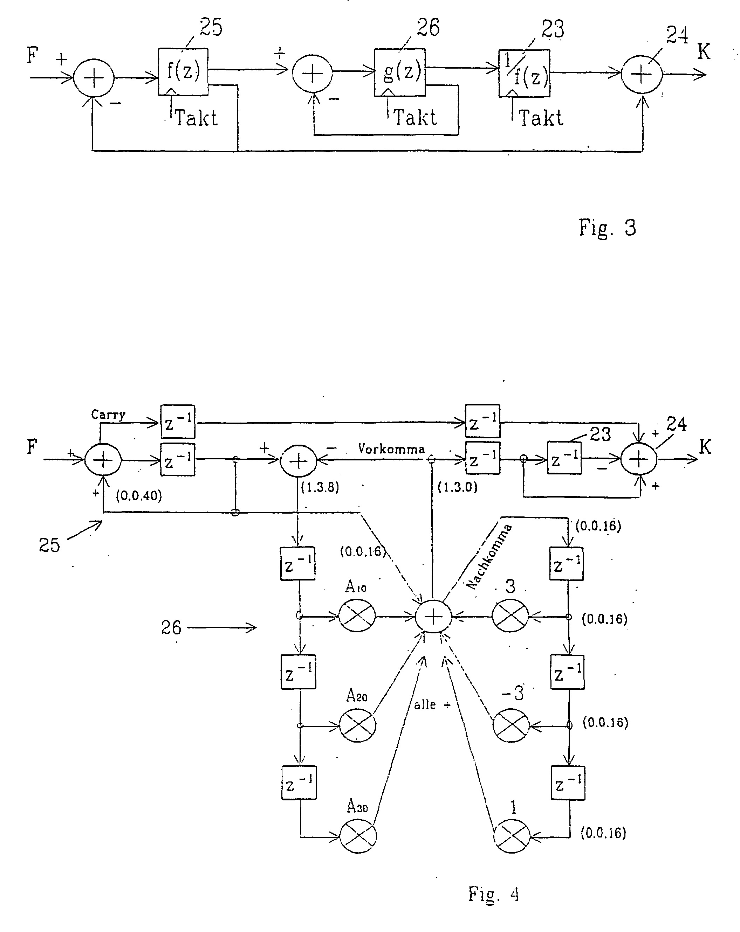

Die Bitbreiten der Multiplizierer 16, 17, 18 sind wesentlich weniger kritisch als die Bitbreite der Multiplizierer 19 bis 21, durch welche die Verstärkung bei Tiefenfrequenzen und damit die Unterdrückung des Quantisierungsgeräusches bestimmt wird. Außerdem muß für eine ausreichende Frequenzauflösung der gebrochene Anteil F mit einer Bitbreite von ca. 40 Bit verrechnet werden. Aus diesen Gründen ist es vorteilhaft, vor dem in Figur 2 dargestellten Filter einen zusätzlichen Integrator 25 oder ein weiteres IIR-Tiefpaßfilter niedrigerer Ordnung aber hoher Bitbreite mit einem eigenen Regelkreis vorzuschalten, wie dies Figur 3 zeigt. Für das nachfolgende IIR-Tiefpaßfilter 26 reicht dann eine Bitbreite von 16 aus, um eine Unterdrückung des Quantisierangsgeräusches auf 150dB zu erreichen. Die Korrekturwerte des zweiten Regelkreises dürfen erst nach Bildung der Umkehrfunktion vom ersten Regelkreis zu den Werten des ersten Regelkreises hinzuaddiert werden, wie dies durch die Umkehrstufe 23 angedeutet ist, da der erste Regelkreis 25 ja auf sein Ausgangssignal regelt. Nach Bildung der Umkehrfunktion in dieser Umkehrstufe 23 erfolgt im Addierer 24 dann die Addition mit dem Ausgangswert des ersten Regelkreises zum Gesamtkorrekturwert K.

Figur 4 zeigt die Gesamtschaltung eines derartigen Integrationskreises mit einem im Sinne der Figur 3 vorgeschalteten Integrator und einem nachfolgenden HR-Filter dritter Ordnung. Die Unterdrückung des Quantisierungsgeräusches entspricht damit dem einer Vierfach-Integration. Die Breite des ersten Addierers beträgt 40 Bit. Es wird weder Vorkomma noch Vorzeichenbit benötigt. Das Carrybit bestimmt wie bei einer Einfachintegration, wann ein Korrekturwert ausgegeben wird.

Das erfindungsgemäße Prinzip kann sowohl bei Synthesizern angewendet werden, die im Sinne des Ausführungsbeispiels den Frequenzteiler im Referenzzweig aufweisen als auch bei Synthesizern, bei denen der Teiler in der Regelschleife zwischen phasengeregeltem Oszillator und Phasendetektor angeordnet ist.

**Patentansprüche**

1. Nach dem Prinzip der fraktionalen Frequenzsynthese arbeitender Frequenzsynthesizer
   mit einem phasengeregelten Oszillator (1),
   einem Phasendetektor (2),
   einer Referenzfrequenzquelle (5),
   einem Frequenzteiler (3), der auf ganzzahlige Teilungsverhältnisse (N) einstellbar ist,
   einer Einstellvorrichtung (6), in welcher ein gewünschtes gebrochenes rationales Teilungsverhältnis (P, F) des Frequenzteilers (3) als Digitalwert einstellbar ist,
   und einer Steuerschaltung (7), die einen Integrator aufweist, dessen Ausgangswert dem ganzzahligen Anteil (P) des gewünschten gebrochenen Teilungsverhältnisses (P, F) als Korrekturwert (K) hinzuaddiert wird, wobei mit diesem korrigierten Ausgangswert (9) das ganzzahlige Teilungsverhältnis (N) des Frequenzteilers (3) so gesteuert wird, daß ein dem gebrochenen Anteil (F) des gewünschten Teilungsverbältnisses entsprechendes gebrochenes Teilungsverhältnis simuliert und gleichzeitig das durch das periodische Umschalten des Teilungsverhältnisses entstehende trägernahe Phasenrauschen der Ausgangsfrequenz reduziert wird,
   **dadurch gekennzeichnet,**
   **daß** als Integrator ein IIR-Tiefpaßfilter erster oder höherer Ordnung benutzt wird, von dem am Ausgang des IIR-Filters erzeugten integrierten Wert nur der Vorkommaanteil als Korrekturwert (K) zum Eingang (10) rückgekoppelt wird und einem ersten Register (12) des IIR-Tiefpaßfilters die Differenz zwischen dem rückgekoppelten Korrekturwert (K) und dem gebrochenen Anteil (F) zugeführt wird.

2. Synthesizer nach Anspruch 1,
   **dadurch gekennzeichnet,**
   **daß** von dem am Ausgang der IIR-Tiefpaßfilters erzeugten integrierten Wert der Nachkommaanteil einem zweiten Register (14) des IIR-Tiefpaßfilters zugeführt wird.

3. Synthesizer nach Anspruch 1 oder 2, **dadurch gekennzeichnet, daß** mehrere IIR-Tiefpaßfilter erster oder höherer Ordnung in Kette hintereinander geschaltet sind und der Korrekturwert (K) vom Ausgang des letzteren IIR-Tiefpaßfilters der Kette zum Eingang der Kette rückgekoppelt wird.

4. Synthesizer nach Anspruch 1 oder 2, **dadurch gekennzeichnet, daß** mehrere IIR-Tiefpaßfilter erster oder höherer Ordnung in Kette hintereinander geschaltet sind und der Korrekturwert für jedes einzelne Tiefpaßfilter von seinem Ausgang zum Eingang rückgekoppelt wird.

5. Synthesizer nach Anspruch 4, **dadurch gekennzeichnet, daß** vor dem IIR-Tiefpaßfilter erster oder höherer Ordnung ein weiterer Integrator (25) oder ein weiteres IIR-Tiefpaßfilter niedrigerer Ordnung in Kette geschaltet ist, das eine höhere Bitbreite als das nachfolgende IIR-Tiefpaßfilter (26) besitzt.

6. Synthesizer nach einem der vorhergehenden Ansprüche, **dadurch gekennzeichnet, daß** die IIR-Tiefpaßfilter als verstärkende Filter ausgebildet sind.

7. Synthesizer nach einem der vorhergehenden Ansprüche, **dadurch gekennzeichnet, daß** die IIR-Tiefpaßfilter so dimensioniert sind, daß sie einen stabilen Rückkopplungs-Regelkreis besitzen.

## Claims

1. Frequency synthesizer operating according to the principle of fractional frequency synthesis, having a phase-controlled oscillator (1), a phase detector (2), a reference frequency source (5), a frequency divider (3) that can be set to integral division ratios (N), an adjustment device (6) in which a desired fractional rational division ratio (P, F) of the frequency divider (3) can be set as a digital value, and a control circuit (7) that has an integrator whose output value is added to the integral component (P) of the desired fractional division ratio (P, F) as a correction value (K), wherein the integral division ratio (N) of the frequency divider (3) is controlled by said corrected output value (9) in such a way that a fractional division ratio corresponding to the fractional component (F) of the desired division ratio is simulated and, at the same time, the phase noise, close to the carrier, of the output frequency due to the periodic switching of the division ratio is reduced, **characterized in that** use is made as integrator of an IIR first-order or higher-order low-pass filter, only the component before the decimal point of the integrated value generated at the output of the IIR filter is fed back to the input (10) as correction value (K) and the difference between the correction value (K) fed back and the fractional component (F) is fed to a first register (12) of the IIR low-pass filter.

2. Synthesizer according to Claim 1, **characterized in that**, of the integrated value generated at the output of the IIR low-pass filter, the component after the decimal point is fed to a second register (14) of the IIR low-pass filter.

3. Synthesizer according to Claim 1 or 2, **characterized in that** a plurality of first-order or higher-order IIR low-pass filters are connected consecutively in a chain and the correction value (K) is fed back from the output of the last IIR low-pass filter of the chain to the input of the chain.

4. Synthesizer according to Claim 1 or 2, **characterized in that** a plurality of first-order or higher-order IIR low-pass filters are connected consecutively in a chain and the correction value for each individual low-pass filter is fed back from its output to the input.

5. Synthesizer according to Claim 4, **characterized in that** there is connected in a chain upstream of the first-order or higher-order IIR low-pass filter a further integrator (25) or a further, lower-order IIR low-pass filter that has a higher bit width than the subsequent IIR low-pass filter (26).

6. Synthesizer according to any of the preceding claims, **characterized in that** the IIR low-pass filter is designed as an amplifying filter.

7. Synthesizer according to any of the preceding claims, **characterized in that** the IIR low-pass filters are given dimensions such that they have a stable feedback control circuit.

## Revendications

1. Synthétiseur de fréquence travaillant selon le principe de la synthèse de fréquence fractionnaire comportant

un oscillateur à verrouillage de phase (1), un détecteur de phase (2),

une source de fréquences de référence (5),

un diviseur de fréquence (3) pouvant être réglé sur lds rapports de division (N) entiers,

un dispositif d'ajustement (6) dans lequel un rapport de division (P, F) rationnel fractionnaire souhaité du diviseur de fréquence (3) peut être ajusté en tant que valeur numérique,

et un circuit de commande (7) présentant un intégrateur dont la valeur initiale est ajoutée à la partie entière (P) du rapport de division (P, F) fractionnaire souhaité en tant que valeur corrective (K), cette valeur initiale corrigée (9) servant à commander le rapport de division entier (N) du diviseur de fréquence (3) de manière à simuler un rapport de division fractionnaire correspondant à la partie fractionnaire (F) du rapport de division souhaité et, en même temps, à réduire le bruit de phase de la fréquence de sortie, proche de la porteuse, produit par le basculement périodique du rapport de division, **caractérisé en ce que**

on utilise, comme intégrateur, un filtre passe-bas IIR du premier ordre ou d'un ordre supérieur, **en ce que** de la valeur intégrée produite à la sortie du filtre IIR, seule la partie avant la virgule est rebouclée à l'entrée (10) en tant que valeur corrective (K) et **en ce que** la différence entre la valeur corrective rebouclée (K) et la partie fractionnaire (F) est délivrée à un premier registre (12) du filtre passe-bas IIR.

2. Synthétiseur selon revendication 1,
**caractérisé en ce que**
la partie après la virgule de la valeur intégrée produite à la sortie du filtre passe-bas IIR est délivrée à un deuxième registre (14) du filtre passe-bas IIR.

3. Synthétiseur selon revendication 1 ou 2,
**caractérisé en ce que**
plusieurs filtres passe-bas IIR du premier ordre ou d'un ordre supérieur sont branchés l'un derrière l'autre en chaîne et **en ce que** la valeur corrective (K) est rebouclée à l'entrée de la chaîne depuis la sortie du dernier filtre passe-bas IIR.

4. Synthétiseur selon revendication 1 ou 2,
**caractérisé en ce que**
plusieurs filtres passe-bas IIR du premier ordre ou d'un ordre supérieur sont branchés l'un derrière l'autre en chaîne et **en ce que** la valeur corrective de chaque filtre passe-bas est rebouclée depuis sa sortie vers l'entrée.

5. Synthétiseur selon revendication 4,
**caractérisé en ce que**
avant le filtre passe-bas IIR du premier ordre ou d'un ordre supérieur; un autre intégrateur (25) ou un autre filtre passe-bas IIR d'un ordre inférieur est branché en chaîne, possédant une largeur de bit supérieure à celle du filtre passe-bas IIR suivant.

6. Synthétiseur selon l'une quelconque des revendications précédentes,
**caractérisé en ce que**
les filtres passe-bas IIR sont agencés en tant que filtres amplificateurs.

7. Synthétiseur selon l'une quelconque des revendications précédentes,
**caractérisé en ce que**,
les filtres passes-bas IIR sont dimensionnés de façon à posséder un circuit de régulation du rebouclage stable.

Fig. 1

Fig.2

Fig. 3

Fig. 4